# EUROPÄISCHE PATENTSCHRIFT

(11) **EP 0 370 331 B1**
(45) Veröffentlichungstag und Bekanntmachung des Hinweises auf die Patenterteilung: **21.07.1993**
(21) Anmeldenummer: 89120846.4
(22) Anmeldetag: 10.11.1989
(51) Int. Cl.: C08J 5/18, C08L 23/12, C08K 3/00

(54) **Verwendung einer Kunststoff-Folie**
Use of a plastic sheet
Utilisation d'une feuille à base de plastique

(30) Priorität: 19.11.1988 DE 3839120
(43) Veröffentlichungstag der Anmeldung: 30.05.1990
(73) Patentinhaber: 4P Folie Forchheim GmbH, D-91299 Forchheim (DE)
(72) Erfinder: Topf, Wolfgang, Dr., D-8550 Forchheim (DE); Lausmann, Hans, D-8551 Hausen (DE)
(74) Vertreter: Hutzelmann, Gerhard

(56) Entgegenhaltungen:
- EP-A- 0 220 433
- EP-A- 0 263 964
- CHEMICAL ABSTRACTS, Band 98, Nr. 22, 30. Mai 1983, Seite 51, Zusammenfassung Nr. 180680b, Columbus, Ohio, US
- CHEMICAL ABSTRACTS, Band 84, Nr. 2, 12. Januar 1976, Seite 53, Zusammenfassung Nr. 6079p, Columbus, Ohio, US

## Beschreibung

Die Erfindung betrifft die Verwendung einer einschichtigen Kunststoff-Folie aus orientiertem Polypropylen (OPP) als Abdeck- und/oder Trennfolie bei der Herstellung von Schichtstoffplatten.

Zum Herstellen von Leiterplatten für die Elektroindustrie und von Schichtstoffplatten für die Möbelindustrie werden bisher besonders beschichtete Papiere und zum Teil verhältnismäßig teure Spezialfolien eingesetzt. Normale Kunststoffolien waren dafür infolge ihrer hochglänzenden, ebenen und glatten Oberfläche nicht geeignet.

Aus der EP-A- 0 263 964 ist darüber hinaus eine Mehrschichtfolie als Trennfolie zur Herstellung dekorativer Schichtstoffplatten bekannt, die durch Coextrusion hergestellt und biaxial streckorientiert ist. Diese Mehrschichtfolie enthält eine Basisschicht aus Polypropylen sowie eine Deckschicht aus Propylenpolymeren und Polydiorganosiloxan.

Mit einer solchen Mehrschichtfolie wird zwar eine ausreichend matte Oberflächenstruktur der Schichtstoffplatten gewährleistet und auch ein weitgehend problemloses Ablosen nach dem Verpressen erzielt, doch ist diese Mehrschichtfolie in der Herstellung verhältnismäßig teuer.

Der Erfindung liegt die Aufgabe zugrunde, eine an sich sehr preisgünstige orientierte Monofolie aus Polypropylen so auszugestalten, daß sie für den genannten Zweck einsetzbar ist.

Erfindungsgemäß wird dies dadurch gelöst, daß die Polypropylen-Folie anorganische Füllstoffe wie z.B. CaCO₃, BaSO₄ oder Silikate in einer Menge von 5 bis 25%, vorzugsweise 7 bis 18% und in einer Korngröße von 1 bis 10µm, vorzugsweise 2 bis 5µm enthält, und daß die Folie eine Rauhtiefe von 5 bis 15µm, vorzugsweise 6 bis 10µm, aufweist.

Gegenüber den bisher benutzten Papieren weist die erfindungsgemäße Kunststoffolie eine erheblich größere Reißfestigkeit auf, so daß das Ablösen nach dem Verpressen der Schichtstoffplatten wesentlich erleichtert wird.

Gegenüber den ebenfalls bekannten Spezialfolien bzw. Mehrschichtfolien ergibt sich dagegen eine ganz wesentliche finanzielle Ersparnis. Zudem wird die Rauhigkeit der erfindungsgemäß verwendeten Folie auf die Oberfläche der Leiterplatte übertragen, so daß diese blendfrei wird, was für die Weiterverarbeitung sehr günstig ist.
Auch die Bedruckbarkeit der Leiterplatte wird dadurch ganz erheblich verbessert.

Nachstehend sind die Werte für zwei erfindungsgemäße Kunststoff-Folien aufgelistet:

| Qualität | Füllstoff | Gehalt | Rauhtiefe | Oberflächenglanz |
|---|---|---|---|---|
| 1 | CaCO₃ | 8% | 6,0µm | 13% |
| 2 | CaCO₃ | 16% | 8,5µm | 0% |

Dabei wurde die Rauhtiefe an einem Hommel Tester T 1000 und der Oberflächenglanz nach DIN 67 530 unter einem Winkel von 60° gemessen. Der Oberflächenglanz ergab sich nach dem Verpressen der Kunststoff-Folie mit einer Leiterplatte aus Phenol-Melaminharz- Papier.

## Patentansprüche

1. Verwendung einer einschichtigen Kunststoff-Folie aus orientiertem Polypropylen als Abdeck- und/oder Trennfolie bei der Herstellung von Schichtstoffplatten, **dadurch gekennzeichnet**, daß die Polypropylen-Folie anorganische Fullstoffe wie z.B. CaCO₃, BaSO₄, Silikate in einer Menge von 5 bis 25%, vorzugsweise 7 bis 18% und in einer mittleren Korngroße von 1 bis 10µm, vorzugsweise 2 bis 5µm enthält, und daß die Folie eine Rauhtiefe von 5 bis 15µm, vorzugsweise 6 bis 10µm, aufweist.

## Claims

1. Use of a single-layer plastic film made from oriented polypropylene as a backing and/or separating film in the production of laminated boards, wherein the polypropylene film contains inorganic fillers such as CaCO₃, BaSO₄, silicates in volumes of 5 to 25% preferably 7 to 18% and an average grain size of 1 to 10 µm preferably 2 to 5µm and wherein the film has a roughness depth of 5 to 15 µm, preferably 6 to 10µm.

## Revendications

1. Utilisation d'une feuille plastique à une strate en polypropylène orienté en tant que feuille de revêtement et/ou de séparation pour la fabrication de panneaux stratifiés, caractérisée par le fait que la feuille de polypropylène contient des charges minérales telles que par exemple du CaCO₃, du BaSO₄, des silicates en une quantité de 5 à 25%, de préférence de 7 à 18% et avec une granulométrie moyenne de 1 à 10 µm, de préférence de 2 à 5 µm, et par le fait que la feuille a une profondeur de rugosité de 5 à 15 µm, et de préférence de 6 à 10 µm.
